# EUROPEAN PATENT APPLICATION

(11) **EP 4 746 659 A1**
(43) Date of publication of application: **20.05.2026**
(21) Application number: 24860089.2
(22) Date of filing: 17.06.2024
(51) Int. Cl.: H10K 59/80

(54) **DISPLAY APPARATUS**

(30) Priority: 01.09.2023 KR 20230116402
(71) Applicant: Samsung Electronics Co., Ltd., Suwon-si, Gyeonggi-do 16677 (KR)
(72) Inventor: KIM, Sru, Suwon-si, Gyeonggi-do 16677 (KR); DO, Gyusung, Suwon-si, Gyeonggi-do 16677 (KR); KIM, Dongri, Suwon-si, Gyeonggi-do 16677 (KR)
(74) Representative: Gulde & Partner
(86) International application number: PCT/KR2024/008353
(87) International publication number: WO 2025/048165

(57) **Abstract**

A display apparatus according to an embodiment may include a display panel, a rear chassis arranged at a rear of the display panel, a heating device arranged at a rear of the rear chassis and having a first width along a first direction, and a heat pipe disposed on the heating device and having a second width exceeding the first width along the first direction.

## Description

### Technical Field

The present disclosure relates to a display apparatus, and more particularly, to a display apparatus having an improved internal structure.

### Background Art

With the recent miniaturization and integration of various electronic devices, the amount of heat generated per square centimeter has increased to several hundred watts. To effectively dissipate this heat and eliminate localized hot spots, a cooling device with high thermal conductivity is required. Cooling methods may be categorized into a single-phase liquid cooling method, which does not involve a phase change in coolant, and a two-phase liquid cooling method, which involves a phase change in the coolant, depending on a temperature range of a heat-generating portion. The two-phase cooling method may handle a wider range of heat generation than the single-phase cooling method.

Among various cooling devices, heat pipes are widely used due to their very high thermal conductivity. The characteristics of such heat pipes are due to their internal wick structure, but a manufacturing process for forming this wick structure is complex, making miniaturization and integration difficult.

### Disclosure of Invention

### Solution to Problem

A display apparatus according to an embodiment may include a display panel and a rear chassis arranged at a rear of the display panel.

According to an embodiment, the display apparatus may include a heating device arranged between the display panel and the rear chassis and having a first width along a first direction.

According to an embodiment, the display apparatus may include a heat pipe that is arranged between the rear chassis and the heating device and has a second width exceeding the first width along the first direction.

### Brief Description of Drawings

FIG. 1 is a front perspective view of a display apparatus according to an embodiment.
FIG. 2 is a rear perspective view of a display apparatus according to an embodiment.
FIG. 3 is a plan view of a rear chassis, a heating device, and a heat pipe, according to an embodiment.
FIG. 4 is a perspective view of a heat pipe according to an embodiment.
FIG. 5 is a cross-sectional view of the heat pipe taken along line A-A of FIG. 4.
FIG. 6 is a cross-sectional view of the heat pipe taken along line B-B of FIG. 4.
FIG. 7 is an exploded perspective view of a rear chassis, a heating device, and a heat pipe, according to an embodiment.
FIG. 8 is a cross-sectional perspective view of a rear chassis, a heating device, and a heat pipe, according to an embodiment.
FIG. 9 is a partial cross-sectional view of the heat pipe taken along line A-A of FIG. 4.
FIG. 10 is a cross-sectional view of a heat pipe according to an embodiment.
FIG. 11 is a perspective view of a heat pipe according to an embodiment.
FIG. 12 is a cross-sectional view of the heat pipe illustrated in FIG. 11.

### Mode for the Invention

Hereinafter, a configuration and an operation according to the disclosure will be described in detail through embodiments illustrated in the accompanying drawings.

Terms used in the present specification will be briefly described and then the present disclosure will be described in detail.

The terms used in the present disclosure are general terms currently widely used in the art by taking into account functions described in the present disclosure, but may vary according to an intention of a skilled person in the related art, precedent cases, advent of new technologies, etc. Furthermore, specific terms may be arbitrarily selected by the applicant, and in this case, the meaning of the selected terms will be described in detail in the relevant description of the disclosure. Thus, the terms used herein should be defined not by simple appellations thereof but based on the meaning of the terms together with the overall description of the present disclosure.

Throughout the specification, when a part "includes" or "comprises" an element, unless there is a particular description contrary thereto, it is understood that the part may further include other elements, not excluding the other elements.

Furthermore, the terms such as "first", "second", etc. are not intended to limit components but are used to distinguish one component from another component.

An embodiment of the present disclosure is described in detail below with reference to the accompanying drawings so that the embodiment may be easily implemented by one of ordinary skill in the art. However, the present disclosure may be implemented in different forms and is not limited to an embodiment set forth herein. In addition, parts not related to descriptions of the present disclosure are omitted to clearly explain the present disclosure in the drawings, and like reference numerals denote like elements throughout.

Moreover, as used in the following description, the terms "upper side," "lower side," and "front-rear direction" are defined based on the drawings, and the shape and position of each component are not limited by these terms.

Hereinafter, an embodiment of the present disclosure is described in detail with reference to the accompanying drawings.

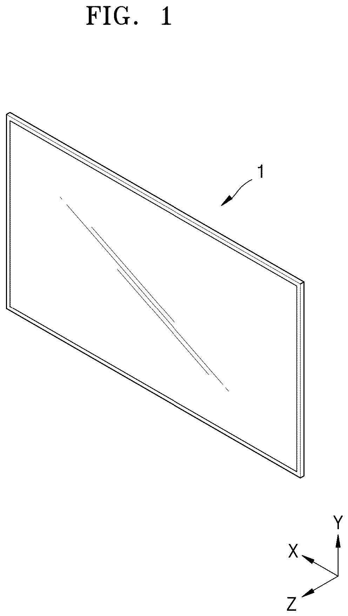

FIG. 1 is a front perspective view of a display apparatus according to an embodiment.

Referring to FIG. 1, a display apparatus 1 is capable of processing an image signal received from the outside and visually displaying the processed image. Hereinafter, an example in which the display apparatus 1 is a television (TV) is illustrated, but the present disclosure is not limited thereto. For example, the display apparatus 1 may be implemented in various forms, such as a monitor, a portable multimedia device, a portable communication device, etc., but the form of display apparatus 1 is not limited as long as it is an apparatus that visually displays an image.

**In** addition, the display apparatus 1 may be a large format display (LFD) installed outdoors, such as on a building rooftop or at a bus stop. Here, "outdoors" is not necessarily limited to outside, and the display apparatus 1 according to an embodiment may also be installed in indoor locations such as a subway station, shopping mall, movie theater, company, or store, as long as they are places where a large number of people can come and go.

The display apparatus 1 may receive content, including video signals and audio signals, from various content sources, and output video and audio corresponding to the video signals and audio signals. For example, the display apparatus 1 may receive content data via a broadcast receiving antenna or a wired cable, receive content data from a content playback device, or receive content data from a content provision server of a content provider.

In the following description, a first direction X refers to one of the directions parallel to an upper surface of the display apparatus 1, e.g., a width direction of the display apparatus 1. A second direction Y refers to a direction that is orthogonal to the first direction X among the directions parallel to the upper surface of the display apparatus 1, e.g., a longitudinal direction of the display apparatus 1. A third direction Z refers to a thickness direction of the display apparatus 1. A rear refers to the third direction Z.

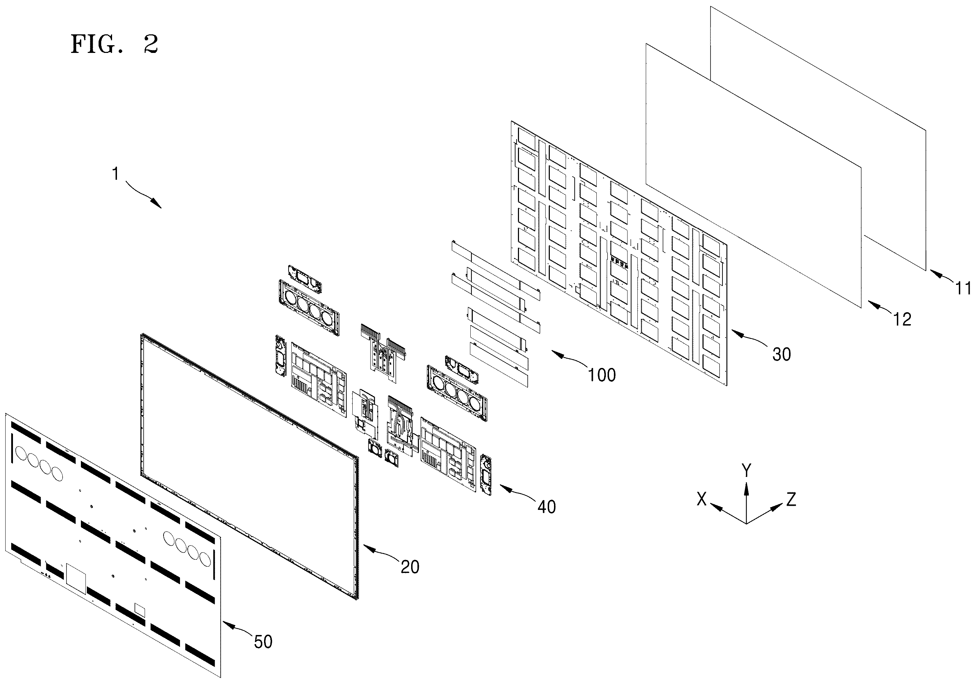

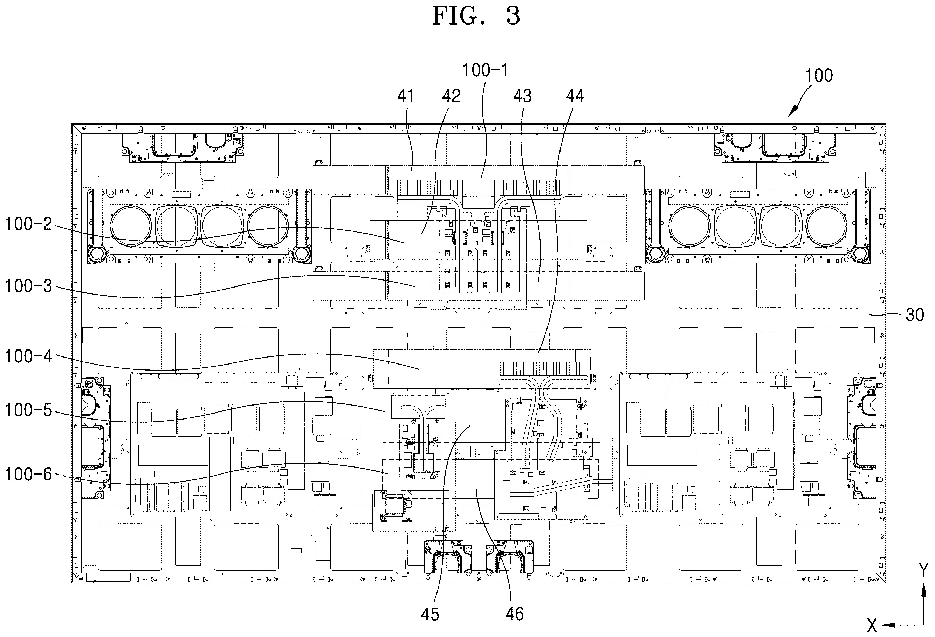

FIG. 2 is a rear perspective view of a display apparatus according to an embodiment. FIG. 3 is a plan view of a rear chassis, a heating device, and a heat pipe, according to an embodiment.

Referring to FIGS. 2 and 3, according to an embodiment, the display apparatus 1 may include a display panel 10, a front chassis 20 that extends along a periphery of the display panel 10 and cover side surfaces of the display panel 10, a rear chassis 30 that covers a rear surface of the display panel 10, a heating device 40 arranged at a rear of the rear chassis 30, a rear cover 50 provided to cover a rear surface of the rear chassis 30, and a heat pipe 100 disposed on the heating device 40.

The display panel 10 may be referred to as a display. According to an embodiment, the display panel 10 may extend along a plane (an XY plane) corresponding to the upper surface of the display apparatus 1. The display panel 10 may include a self-emissive panel 11 configured to emit light on its own and display an image, and a heat dissipation sheet 12 attached to a rear surface of the self-emissive panel 11 and provided to dissipate heat.

The self-emissive panel 11 may be configured to display an image by using an organic light-emitting device (OLED). Because the self-emissive panel 11 does not include a backlight unit at its rear, it may be thinner than a light-receiving panel. However, the present disclosure is not limited thereto, and the self-emissive panel 11 may also be replaced with a liquid crystal display (LCD) panel including a backlight unit.

The heat dissipation sheet 12 may be provided in a size corresponding to the self-emissive panel 11. According to an embodiment, the heat dissipation sheet 12 may be attached to the rear surface of the self-emissive panel 11 by using an adhesive member such as an adhesive or double-sided tape. The heat dissipation sheet 12 may be attached to the rear surface of the self-emissive panel 11 to dissipate heat. The heat dissipation sheet 12 may increase its contact area with the self-emissive panel 11 to effectively absorb heat from the self-emissive panel 11. For this purpose, the heat dissipation sheet 12 and the self-emissive panel 11 may be bonded together by the adhesive member. The heat dissipation sheet 12 may include at least one of graphite, aluminum, and copper.

The front chassis 20 may be referred to as an external frame. According to an embodiment, the front chassis 20 may be provided to cover the side surfaces of the display panel 10. The front chassis 20 may be formed to extend along the periphery of the display panel 10. Thus, the front chassis 20 may be provided in a substantially rectangular ring shape.

The rear chassis 30 may be provided in a size corresponding to the display panel 10. The rear chassis 30 may be provided to cover the rear surface of the display panel 10. According to an embodiment, the rear chassis 30 may form a rear exterior of the display apparatus 1 together with the rear cover 50.

The rear cover 50 may be coupled to the rear of the rear chassis 30. According to an embodiment, the rear cover 50 may be coupled to the rear of the rear chassis 30, thereby forming an internal space therebetween. The heating device 40 that emits heat may be arranged within the internal space formed between the rear cover 50 and the rear chassis 30. For example, the heating device 40 may include one or more of a printed circuit board (PCB) or a power input device. When the heating device 40 includes a plurality of PCBs, the plurality of PCBs may include one or more of a T-con board (timing controller), a main board controlling components of the display apparatus 1, and a power board. For example, as illustrated in FIG. 3, the plurality of PCBs may include a first heating device 41 to a sixth heating device 46, wherein the first heating device 41 to the sixth heating device 46 may be any one of a T-con board (timing controller), a main board, and a power board. In addition, according to an embodiment, the first heating device 41 to the sixth heating device 46 may be arranged behind and/or on the rear surface of the rear chassis 30 to be spaced apart from the rear chassis 30.

The heat pipe 100 may absorb the heat generated by the heating device 40 and release it to the outside. According to an embodiment, the heat pipe 100 is disposed on the heating device 40, and when a plurality of heating devices 40 are provided, a plurality of heat pipes 100 may also be arranged to respectively correspond to the plurality of heating devices 40. For example, when the plurality of heating devices 40 include the first heating device 41 to the sixth heating device 46, the plurality of heat pipes 100 may also include a first heat pipe 100-1 to a sixth heat pipe 100-6.

According to an embodiment, the heat pipe 100 may convert heat into kinetic energy of a fluid and dissipate heat through fluid motion. The heat pipe 100 has a simple structure in which a coolant, as described below, is sealed within a plurality of cooling channels and operates passively, thereby enabling miniaturization and a lightweight design. The heat pipe 100 disposed on the heating device 40 is described in detail below.

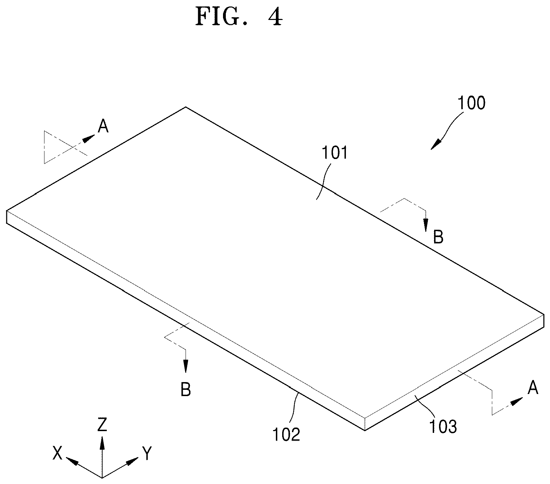

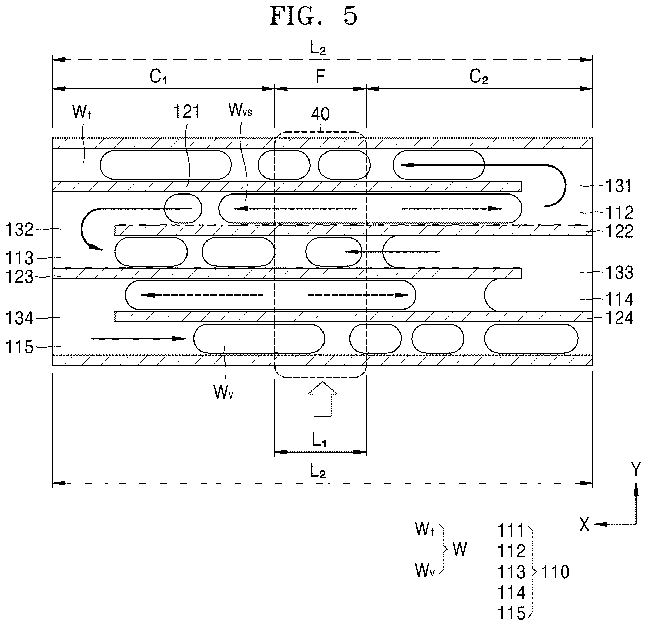

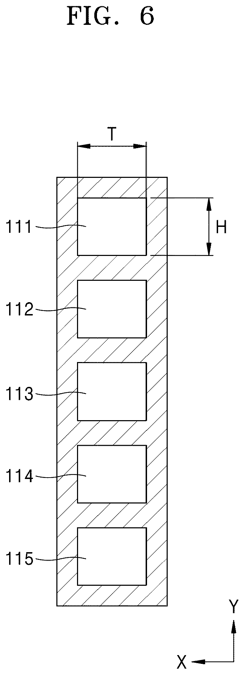

FIG. 4 is a perspective view of a heat pipe according to an embodiment. FIG. 5 is a cross-sectional view of the heat pipe taken along line A-A of FIG. 4. FIG. 6 is a cross-sectional view of the heat pipe taken along line B-B of FIG. 4.

Referring to FIGS. 4 to 6, according to an embodiment, the heat pipe 100 may include a plurality of cooling channels 110 and a coolant W moving along the plurality of cooling channels 110. For example, the plurality of cooling channels 110 may be maintained in a sealed state isolated from the outside. For instance, the heat pipe 100 may include an upper surface 101 and a lower surface 102 extending along a plane (an XY plane), and side surfaces 103 arranged between the upper surface 101 and the lower surface 102. In this case, the plurality of cooling channels 110 may be arranged within a receiving space provided between the upper surface 101, the lower surface 102, and the side surfaces 103.

According to an embodiment, the heat pipe 100 may include one or more of materials having relatively high thermal conductivity, such as aluminum, copper, and stainless steel. When the heat pipe 100 is provided in a plate-like shape having the upper surface 101, the lower surface 102, and the side surfaces 103, the heat pipe 100 may be formed using an extrusion method. In this case, the upper surface 101, the lower surface 102, the side surfaces 103, and the plurality of cooling channels 110 included in the heat pipe 100 may be integrally formed. However, the present disclosure is not limited thereto, and the heat pipe 100 may also be provided in a form where the upper surface 101, the lower surface 102, the side surfaces 103, and the plurality of cooling channels 110 manufactured in different ways are combined.

When the heating device 40 has a first width L₁ along the first direction X, the heat pipe 100 may have a second width L₂ exceeding the first width L₁ along the first direction X. In other words, a region where the coolant W moves may be larger than a heating region F corresponding to the heating device 40. Therefore, the plurality of cooling channels 110 through which the coolant W moves may extend beyond the heating region F along the first direction X.

According to an embodiment, the plurality of cooling channels 110 may be aligned along the second direction Y perpendicular to the first direction X. For example, the plurality of cooling channels 110 may include a first cooling channel 111 to a fifth cooling channel 115, each having a second width L₂ along the first direction X. The first cooling channel 111 to the fifth cooling channel 115 may be arranged along the second direction Y perpendicular to the first direction X, with partition walls 121-124 disposed therebetween.

One or more of both ends of adjacent cooling channels among the plurality of cooling channels 110 may be connected to be in fluid communication. For example, the first cooling channel 111 and the second cooling channel 112 may be arranged adjacent to each other with the first partition wall 121 therebetween. In this case, one end of the first partition wall 121, e.g., a right end 131, may be removed so that the first cooling channel 111 and the second cooling channel 112 may be connected to be in fluid communication. Furthermore, the second cooling channel 112 and the third cooling channel 113 may be arranged adjacent to each other with the second partition wall 122 therebetween. In this case, one end of the second partition wall 122, e.g., a left end 132, may be removed so that the second cooling channel 112 and the third cooling channel 113 may be connected to be in fluid communication. In the same manner, one end of the third partition wall 123, e.g., a right end 133, may be removed so that the third cooling channel 113 and the fourth cooling channel 114 may be connected to be in fluid communication. In addition, one end of the fourth partition wall 124, e.g., a left end 134, may be removed so that the fourth cooling channel 114 and the fifth cooling channel 115 may be connected to be in fluid communication.

As described above, by removing one end of each of the first to fourth partition walls 121 to 124, the first cooling channel 111 to the fifth cooling channel 115 may be connected into a single channel. In this case, while circulating through the first cooling channel 111 to the fifth cooling channel 115, the coolant W may absorb the heat generated by the heating device 40 and release it to the outside.

According to an embodiment, the coolant W may be determined based on an operating temperature of the heating device 40. For example, the coolant W may include one or more of refrigerant R-245fa, refrigerant R-1233zd, 3M Novec series, Chemours Opteon SF33, acetone, and distilled water. An operating temperature range of the heating device 40 at which vapor pressure may occur under atmospheric pressure conditions may be 15 °C for refrigerant R-245fa, 19 °C for refrigerant R-1233zd, and 100 °C for distilled water. However, the present disclosure is not limited thereto, and coolant W that operates outside the operating temperature range of the heating device 40 may also be used.

According to an embodiment, after the plurality of cooling channels 110 have been evacuated to form a vacuum, the coolant W may be filled at an arbitrary ratio. As described above, the plurality of cooling channels 110 may include a structure in which a single long, interconnected cooling channel is bent to form multiple turns. In this case, the plurality of cooling channels 110 may be provided in the form of fine tubes having a predetermined cross-sectional shape. Accordingly, an interior of the plurality of cooling channels 110 may be filled with a structure (slug-train unit) in which liquid slugs W_{f} and vapor plugs Wᵥ repeatedly alternate due to capillary pressure.

As an example, each cooling channel included in the plurality of cooling channels 110 may have a rectangular cross-section perpendicular to the first direction X. For example, as illustrated in FIG. 6, each of the first cooling channel 111 to the fifth cooling channel 115 may have a rectangular cross-section with a predetermined width T and a predetermined height H. For example, the height H of the rectangular shape along the second direction Y perpendicular to the first direction X may be at least 2 mm but not more than 4 mm. Furthermore, the width T of the rectangular shape along the third direction Z perpendicular to the first direction X may be at least 0.5 mm but not more than 4 mm. However, the present disclosure is not limited thereto, and each cooling channel included in the plurality of cooling channels 110 may also have a circular cross-section, perpendicular to the first direction X, with a predetermined diameter. For example, the diameter of the circular cross-section may be at least 1 mm but not more than 4 mm.

As described above, in a state where heat is not transferred from the heating device 40 to the heat pipe 100, the coolant W located inside the plurality of cooling channels 110 may be filled with a structure (slug-train unit) in which liquid slugs W_{f} and vapor plugs Wᵥ repeatedly alternate. Nucleate boiling may occur in the heating region F due to the amount of heat applied from the heating device 40. Bubbles generated by nucleate boiling may coalesce to form a gas-liquid slug flow Wᵥₛ.

As the gas-liquid slug flow Wᵥₛ forms, a fluid flow accompanied by bidirectional oscillations may be generated while simultaneously producing pressure waves in the plurality of cooling channels 110. Accordingly, the coolant W in the heating region F may move to both ends of the heating region F, e.g., a first cooling region C₁ located at one end of the heating region F and a second cooling region C₂ located at the other end of the heating region F. The coolant W that has moved to the first cooling region C₁ and the second cooling region C₂ may release heat to the outside through convective heat transfer and latent heat transport. Furthermore, at this time, pressure may be applied to the coolant W located in the first cooling region C₁ and the second cooling region C₂. Accordingly, the coolant W located in the first cooling region C₁ and the second cooling region C₂ may move to the heating region F.

As described above, nucleate boiling may occur in the coolant W within the heating region F due to the amount of heat applied from the heating device 40. Bubbles generated by the nucleate boiling may coalesce to form a gas-liquid slug flow Wᵥₛ, and accordingly, the positions of the coolant W located in the heating region F and the coolant W located in the first cooling region C₁ and the second cooling region C₂ may be swapped around. **In** this process, the amount of heat transferred from the heating region F to the coolant W may be released to the outside from the first cooling region C₁ and the second cooling region C₂.

The amount of heat transferred from the heating region F to the coolant W may vary depending on a temperature of the heating device 40 and the first width L₁ of the heating device 40 along the first direction X, across which the heating device 40 is in contact with the plurality of cooling channels 110. To reduce a temperature variation across the entire area of the plurality of cooling channels 110 along the first direction X, the second width L₂, across which the plurality of cooling channels 110 extend along the first direction X, may be determined differently depending on the temperature of the heating device 40 and the first width L₁ of the heating device 40.

For example, the amount of heat transferred from the heating region F to the coolant W needs to be released to the outside from the first cooling region C₁ and the second cooling region C₂. The coolant W that has moved to the first cooling region C₁ and the second cooling region C₂ may release heat to the outside through convective heat transfer and latent heat transport. Accordingly, when the temperature of the heating device 40 and the first width L₁ of the heating device 40 increase, causing the amount of heat transferred from the heating region F to the coolant W to increase, the first cooling region C₁ and the second cooling region C₂ need to be enlarged. On the other hand, when the temperature of the heating device 40 and the first width L₁ of the heating device 40 decrease, causing the amount of heat transferred from the heating region F to the coolant W to decrease, the first cooling region C₁ and the second cooling region C₂ need to be reduced. Therefore, a length across which the plurality of cooling channels 110 extend along the first direction X may be determined based on a length of the heating region F that is in contact with the heating device 40 along the first direction X. For example, a ratio of the first width L₁ of the heating device 40 relative to the second width L₂ of the plurality of cooling channels 110 extending along the first direction X may be at least 20 % but not more than 80 %.

However, the present disclosure is not limited thereto, and the second width L₂ across which the plurality of cooling channels 110 extend along the first direction X may be 'set differently for each of the plurality of cooling channels 110 due to design constraints. In this case, a cooling capacity may be increased by increasing the capacity of the coolant W flowing through the plurality of cooling channels 110. To increase the capacity of coolant W flowing through the plurality of cooling channels 110, a cross-sectional area of each of the plurality of cooling channels 110 may be increased. However, considering a capillary pressure of the coolant W flowing through the plurality of cooling channels 110, there may be limitations to increasing the cross-sectional area of each of the plurality of cooling channels 110.

In addition, for example, widths of the first cooling region C₁ and the second cooling region C₂ along the first direction X may be set to be equal to each other. Accordingly, the first cooling region C₁ and the second cooling region C₂ may be arranged symmetrically about the heating region F. Therefore, the temperature variation across the entire area of the plurality of cooling channels **110** along the first direction X may be relatively reduced.

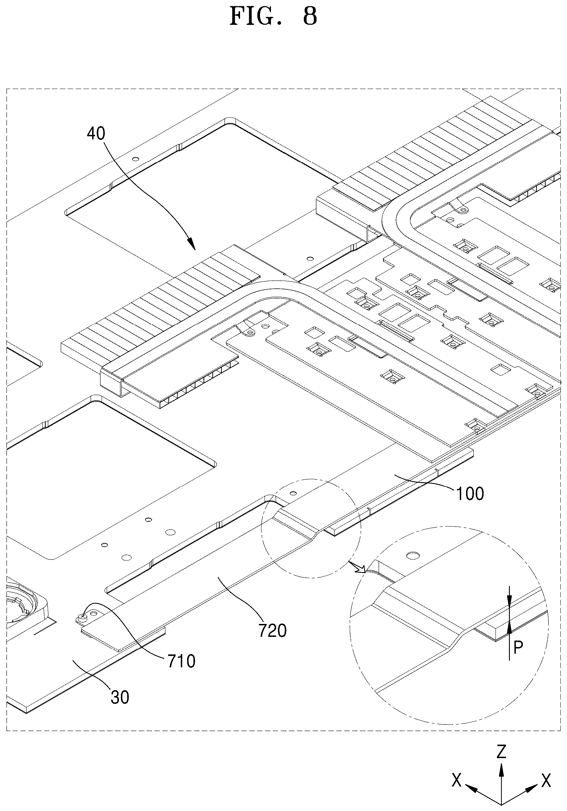

As described above, the amount of heat transferred from the heating region F to the coolant W needs to be released to the outside from the first cooling region C₁ and the second cooling region C₂. The coolant W that has moved to the first cooling region C₁ and the second cooling region C₂ may release heat to the outside through convective heat transfer and latent heat transport. According to an embodiment, the first cooling region C₁ and the second cooling region C₂ may each be arranged to be spaced apart from the rear chassis 30 by a predetermined gap (P of FIG. 8) along the third direction Z perpendicular to the first direction X.

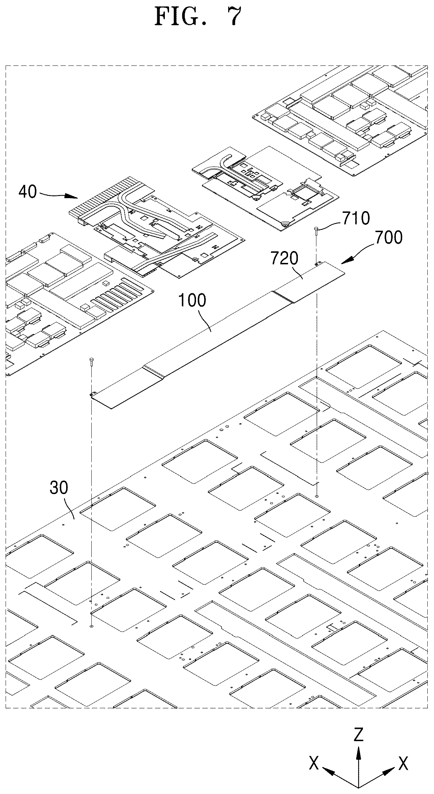

FIG. 7 is an exploded perspective view of a rear chassis, a heating device, and a heat pipe, according to an embodiment. FIG. 8 is a cross-sectional perspective view of a rear chassis, a heating device, and a heat pipe, according to an embodiment.

Referring to FIGS. 7 and 8, the first cooling region C₁ and the second cooling region C₂ may each be arranged to be spaced apart from the rear chassis 30 by the predetermined gap P along the third direction Z perpendicular to the first direction X. However, the present disclosure is not limited thereto, and the predetermined gap P between each of the first cooling region C₁ and the second cooling region C₂ and the rear chassis 30 may be set differently according to design constraints.

According to an embodiment, a fastening device 700 may fix one or more of both ends of the heat pipe 100 to the rear chassis 30. For example, the fastening device 700 may include a connecting member 710 capable of connecting one or more of both the ends of the heat pipe 100 to the rear chassis 30 while maintaining a predetermined gap P therebetween, and a fixing member 720 capable of fixing the connecting member 710 to the rear chassis 30. Accordingly, the first cooling region C₁ and the second cooling region C₂, which are arranged on both sides of the heating region F along the first direction X, may be located to be spaced apart from the rear chassis 30 by the predetermined gap P for heat transfer to the outside. Furthermore, in this case, the plurality of cooling channels 110 may be arranged to contact the heating device 40 in the heating region F.

According to an embodiment, the connecting member 710 may include a bracket shape bent at a predetermined angle. Furthermore, the fixing member 720 may include a screw shape extending along one direction. However, the connecting member 710 and the fixing member 720 are not limited thereto, and any fastening device capable of securing the heat pipe 100 to the rear chassis 30 with a predetermined gap between the heat pipe 100 and the rear chassis 30 may also be used.

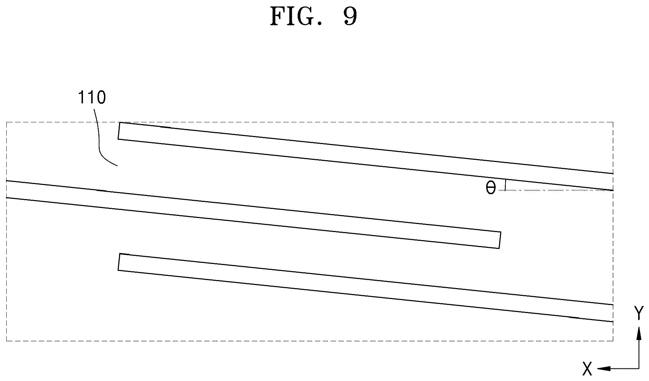

FIG. 9 is a partial cross-sectional view of the heat pipe taken along line A-A of FIG. 4.

As described above, each cooling channel included in the plurality of cooling channels 110 may extend to have a predetermined width along the first direction X. However, the present disclosure is not limited thereto, and each cooling channel included in the plurality of cooling channels 110 may also be arranged to have a predetermined inclination angle relative to each other.

Referring to FIG. 9, according to an embodiment, one cooling channel, e.g., the first cooling channel 111, included in the plurality of cooling channels 110, may be arranged to be inclined at a predetermined angle θ relative to the first direction X. According to an embodiment, the inclination angle θ may be 10 degrees or less.

For example, the interior of the plurality of cooling channels 110 may be filled with a structure (slug-train unit) in which liquid slugs W_{f} and vapor plugs Wᵥ repeatedly alternate due to capillary pressure. Nucleate boiling may occur in the heating region F due to the amount of heat applied from the heating device 40. Bubbles generated by nucleate boiling may coalesce to form a gas-liquid slug flow Wᵥₛ. As the gas-liquid slug flow Wᵥₛ forms, a flow accompanied by bidirectional oscillations may be generated while simultaneously producing pressure waves in the plurality of cooling channels 110.

When the plurality of cooling channels 110 each have the predetermined inclination angle θ with respect to the first direction X, a predetermined downward movement pressure due to gravity may be applied to the coolant W located in the plurality of cooling channels 110. In this case, when the plurality of cooling channels 110 each have a predetermined inclination angle θ of 10 degrees or less with respect to the first direction X, a pressure wave formed by the gas-liquid slug flow Wᵥₛ in the heating region F may exceed the downward movement pressure due to gravity. Accordingly, a flow accompanied by bidirectional oscillations due to the gas-liquid slug flow Wᵥₛ may occur.

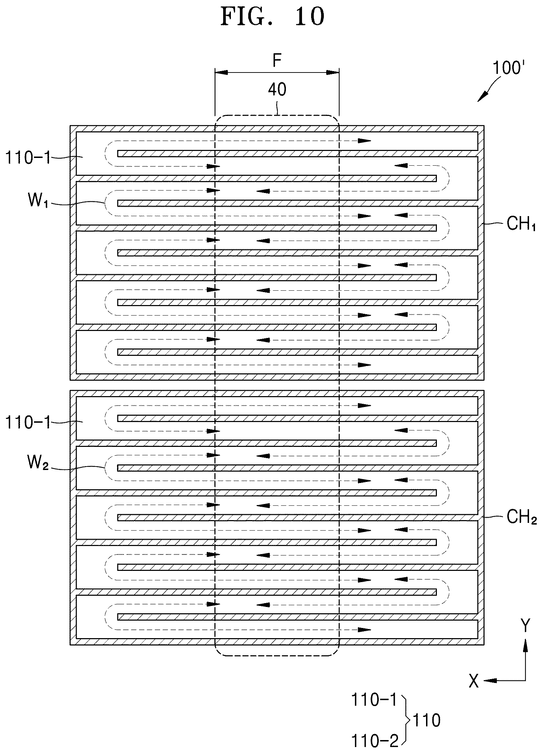

FIG. 10 is a cross-sectional view of a heat pipe according to an embodiment.

Referring to FIG. 10, a heat pipe 100' according to an embodiment may include a plurality of cooling channels 110 grouped into multiple channels. For example, a first plurality of cooling channels 110-1, through which a first coolant W₁ flows, may be arranged in a first channel CH₁. Additionally, a second plurality of cooling channels 110-2, through which a second coolant W₂ flows, may be arranged in a second channel CH₂. In this case, the first plurality of cooling channels 110-1 may be arranged adjacent to the second plurality of cooling channels 110-2 along the second direction Y perpendicular to the first direction X.

According to an embodiment, an operating temperature of the heating device 40 arranged in the heating region F may vary depending on regions. The first plurality of cooling channels 110-1 and the second plurality of cooling channels 110-2 may be respectively arranged on different operating temperature regions of the heating device 40. For example, when the operating temperature of the heating device 40 varies along the second direction Y, the first plurality of cooling channels 110-1 and the second plurality of cooling channels 110-2 may be arranged along the second direction Y corresponding to the operating temperature of the heating device 40. In this case, the first coolant W₁ and the second coolant W₂ may be determined differently according to the operating temperature of the heating device 40.

Furthermore, according to another embodiment, the operating temperature of the heating device 40 arranged in the heating region F may be constant across the region. When the number of cooling channels included in the plurality of cooling channels 110 exceeds 10, a predetermined downward movement pressure due to gravity may be applied to coolant W located in the lowermost cooling channel of the plurality of cooling channels 110. In this case, a pressure wave formed by a gas-liquid slug flow Wᵥₛ in the heating region F may be smaller than the downward movement pressure due to gravity. Accordingly, a flow accompanied by bidirectional oscillations due to the gas-liquid slug flow Wᵥₛ may not occur.

According to an embodiment, the first plurality of cooling channels 110-1 and the second plurality of cooling channels 110-2 may be arranged adjacent to each other along the second direction Y. In this case, the first plurality of cooling channels 110-1 may include ten or fewer cooling channels aligned along the second direction Y. Additionally, the second plurality of cooling channels 110-2 may include ten or fewer cooling channels aligned along the second direction Y. Furthermore, the first coolant W₁ and the second coolant W₂ may include the same material. Accordingly, when the heating region F where the heating device 40 is arranged extends along the second direction Y, the heat pipe 100' including a multi-channel configuration may be arranged to uniformly cool the heating device 40.

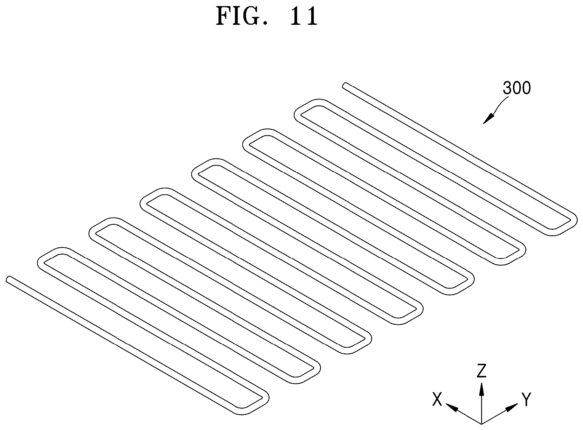

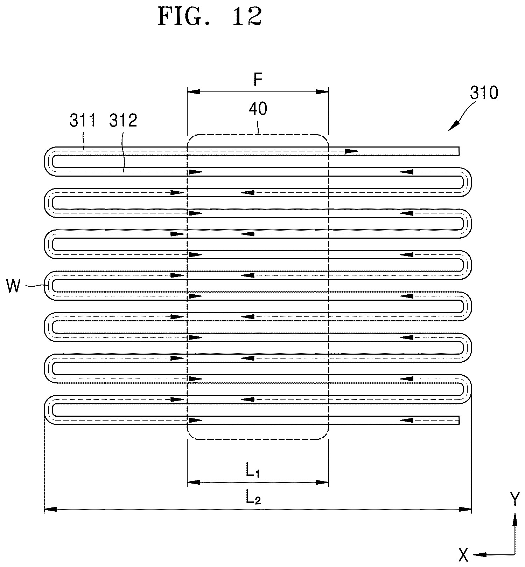

FIG. 11 is a perspective view of a heat pipe according to an embodiment. FIG. 12 is a cross-sectional view of the heat pipe illustrated in FIG. 11.

Referring to FIGS. 11 and 12, a heat pipe 300 according to an embodiment may include a bent cooling channel 310 extending in one direction and integrally formed by being bent a plurality of times, and a coolant W moving along the bent cooling channel 310. For example, the bent cooling channel 310 may be maintained in a sealed state isolated from the outside.

According to an embodiment, the heat pipe 300 may include one or more materials having relatively high thermal conductivity, such as aluminum, copper, and stainless steel. According to an embodiment, when the heat pipe 300 includes the single bent cooling channel 310, the bent cooling channel 310 may be formed using a bending method that involves repeatedly bending the channel extending along the first direction X by bending the channel at one of both ends and then at the other end in a subsequent stage.

When the heating device 40 has a first width L₁ along the first direction X, the bent cooling channel 310 may have a second width L₂ exceeding the first width L₁ along the first direction X. In other words, a region where the coolant W moves may exceed a heating region F corresponding to the heating device 40. Therefore, the bent cooling channel 310 through which the coolant W moves may extend beyond the heating region F along the first direction X.

According to an embodiment, the bent cooling channel 310 may be aligned along the second direction Y perpendicular to the first direction X. For example, the bent cooling channel 310 may include a plurality of cooling channels having a second width L₂ along the first direction X.

Because the bent cooling channel 310 may be formed by bending an integral cooling channel, one or more of both ends of adjacent cooling channels may be connected to be in fluid communication. For example, a first cooling channel 311 and a second cooling channel 312 may be connected to be in fluid communication by using a bending region. Accordingly, the bent cooling channel 310 may be connected as a single fluid channel. In this case, while circulating through the bent cooling channel 310, the coolant W may absorb heat generated by the heating device 40 and release it to the outside.

According to an embodiment, the coolant W may be determined based on an operating temperature of the heating device 40. For example, the coolant W may include one or more of refrigerant R-245fa, refrigerant R-1233zd, 3M Novec series, Chemours Opteon SF33, and distilled water. An operating temperature range of the heating device 40 at which vapor pressure may occur under atmospheric pressure conditions may be 15 °C for refrigerant R-245fa, 19 °C for refrigerant R-1233zd, and 100 °C for distilled water. However, the present disclosure is not limited thereto, and coolant W that is not included in the operating temperature range of the heating device 40 may also be used.

According to an embodiment, after the bent cooling channel 310 has been evacuated into a vacuum, the coolant W may be filled at an arbitrary ratio. As described above, the bent cooling channel 310 may include a structure in which a single long, interconnected cooling channel is bent to form multiple turns. In this case, the bent cooling channel 310 may be provided in the form of fine tubes having a predetermined cross-sectional shape. Accordingly, an interior of the bent cooling channel 310 may be filled with a structure (slug-train unit) in which liquid slugs W_{f} and vapor plugs Wᵥ repeatedly alternate due to capillary pressure. For example, each cooling channel included in the bent cooling channel 310 may have a circular cross-section perpendicular to the first direction X. For example, a diameter of the circular cross-section may be at least 1 mm but not more than 4 mm, but the present disclosure is not limited thereto.

The above-described embodiments are merely examples, and various modifications and other equivalent embodiments may be derived therefrom by one of ordinary skill in the art. Therefore, the true scope of technical protection of the present disclosure will be defined by the technical spirit of the disclosure as indicated by the following claims.

A display apparatus is provided that is capable of reducing temperature variations across an entire region where a heat pipe is arranged to correspond to a heating device that generates heat in a small area.

A display apparatus is provided that is capable of reducing temperature variations across an entire region where a heat pipe is arranged, by arranging a heat pipe having a plurality of channels corresponding to various heating temperatures and a wide heating region.

A display apparatus is provided that includes a heat pipe whose design convenience and manufacturing convenience are enhanced through miniaturization and integration.

The technical solutions to be achieved in this document are not limited to those described above, and other technical solutions not described herein will become apparent to those of ordinary skill in the art from the following description.

A display apparatus according to an embodiment may include a display panel, a rear chassis arranged at a rear of the display panel, a heating device arranged at a rear of the rear chassis and having a first width along a first direction, and a heat pipe disposed on the heating device and having a second width exceeding the first width along the first direction. According to an embodiment of the present disclosure, there may be various effects including reducing temperature variations across the entire region where the heat pipe is arranged.

The heat pipe may include a plurality of cooling channels having a second width along the first direction and being aligned along a second direction perpendicular to the first direction, and a coolant that absorbs heat generated from the heating device while moving along the plurality of cooling channels, wherein one or more of both ends of adjacent cooling channels among the plurality of cooling channels may be connected to be in fluid communication. According to an embodiment of the present disclosure, there may be various effects including the plurality cooling channels included in the heat pipe being interconnected to form a single fluid passage.

A ratio of the first width of the heating device relative to the second width of the plurality of cooling channels may be at least 20 % but not more than 80 %. According to an embodiment of the present disclosure, there may be various effects including reducing temperature variations across the entire region where the plurality of cooling channels are arranged.

The plurality of cooling channels may include a heating region supported by contacting the heating device, a first cooling region located at one end side of the heating region, and a second cooling region located at another end side of the heating region, and the first cooling region and the second cooling region may be arranged to be spaced apart from the rear chassis by a predetermined gap along a third direction perpendicular to the first direction. According to an embodiment of the present disclosure, there may be various effects including dissipating heat to the outside from the cooling regions of the plurality of cooling channels through convective heat transfer and latent heat transport.

The heat pipe may be formed using an extrusion method. According to an embodiment of the present disclosure, providing the heat pipe by using an extrusion method may not only improve manufacturing convenience but also enable the production of an integral heat pipe.

The coolant located in the plurality of cooling channels may repeatedly alternate between a vapor plug and a liquid slug. According to an embodiment of the present disclosure, there may be various effects including filling an interior of the plurality of cooling channels with a structure (slug-train unit) in which a liquid slug W_{f} and a vapor plug Wᵥ repeatedly alternate.

The display apparatus may further include a fastening device for fixing one or more of both ends of the plurality of cooling channels to the rear chassis. According to an embodiment of the present disclosure, there may be various effects including fastening the plurality of cooling channels to the rear chassis with a predetermined gap therebetween.

The plurality of cooling channels are arranged to be inclined at a predetermined inclination angle relative to the first direction, and the inclination angle may be 10 degrees or less. According to an embodiment of the present disclosure, there may be various effects including the generation of a flow accompanied by bidirectional oscillations due to a gas-liquid slug flow Wᵥₛ when a pressure wave formed by the gas-liquid slug flow Wᵥₛ in the heating region exceeds a downward movement pressure due to gravity.

Each cooling channel included in the plurality of cooling channels may have a rectangular cross-section perpendicular to the first direction, a height of the rectangular shape along the second direction perpendicular to the first direction may be at least 2 mm but not more than 4 mm, and a width of the rectangular shape along the third direction perpendicular to the first direction may be at least 0.5 mm but not more than 4 mm. According to an embodiment of the present disclosure, there may be various effects including filling the interior of the plurality of cooling channels with a structure (slug-train unit) where a liquid slug W_{f} and a vapor plug Wᵥ repeatedly alternate due to capillary pressure.

The heat pipe may include one or more of aluminum, copper, and stainless steel. According to an embodiment of the present disclosure, there may be various effects including manufacturing a heat pipe that is easy to manufacture and exhibits excellent heat transfer performance.

The coolant may include one or more of refrigerant R-245fa, refrigerant R-1233zd, 3M Novec series, Chemours Opteon SF33, and distilled water. According to an embodiment of the present disclosure, there may be various effects including arranging the heat pipe corresponding to a heating device having various operating temperatures.

The plurality of cooling channels may include a first plurality of cooling channels through which a first coolant flows and a second plurality of cooling channels through which a second coolant different from the first coolant flows, wherein the first plurality of cooling channels may be arranged adjacent to the second plurality of cooling channels along the second direction perpendicular to the first direction.

The first plurality of cooling channels and the second plurality of cooling channels may each include ten or fewer cooling channels aligned along the second direction perpendicular to the first direction. According to an embodiment of the present disclosure, there may be various effects including the generation of a flow accompanied by bidirectional oscillations due to a gas-liquid slug flow Wᵥₛ when a pressure wave formed by the gas-liquid slug flow Wᵥₛ in the heating region exceeds a downward movement pressure due to gravity.

The heat pipe may include a bent cooling channel extending in one direction and integrally formed by bending a plurality of times. According to an embodiment of the present disclosure, there may be various effects including providing a heat pipe that is easy to manufacture.

The heating device may include one or more of a PCB and a power input device. According to an embodiment of the present disclosure, there may be various effects including providing a heat pipe corresponding to various heating devices.

According to an embodiment, the display apparatus may reduce temperature variations across the entire region where a heat pipe is arranged to correspond to a heating device that generates heat in a small area.

According to an embodiment, the display apparatus may reduce temperature variations across an entire region where a heat pipe is arranged, by arranging a heat pipe having a plurality of channels corresponding to various heating temperatures and a wide heating region.

According to an embodiment, the display apparatus may enhance design convenience and manufacturing convenience through the miniaturization and integration of a heat pipe.

Effects that may be obtained from the present disclosure will not be limited to only the above-described effects, and other effects which are not described herein will become apparent to those of ordinary skill in the art from the following description.

## Claims

1. A display apparatus comprising:
a display panel (10);
a rear chassis (30) arranged at a rear of the display panel;
a heating device (40) arranged at a rear of the rear chassis and having a first width (L₁) along a first direction; and
a heat pipe (100) disposed on the heating device and having a second width (L₂) exceeding the first width along the first direction.

2. The display apparatus of claim 1, wherein
the heat pipe (100) comprises:
a plurality of cooling channels (110) having the second width (L₂) along the first direction and being aligned along a second direction perpendicular to the first direction; and
a coolant (W) that absorbs heat generated from the heating device while moving along the plurality of cooling channels,
wherein one or more of both ends of adjacent cooling channels among the plurality of cooling channels are connected to be in fluid communication.

3. The display apparatus of claim 2, wherein a ratio of the first width (L₁

4. of the heating device (40) relative to the second width (L₂) of the plurality of cooling channels (110) is at least 20 % but not more than 80 %.

5. The display apparatus of claim 2 or 3, wherein
the plurality of cooling channels comprise:
a heating region (F) supported by contacting the heating device;
a first cooling region (C₁) located at one end side of the heating region; and
a second cooling region (C₂) located at another end side of the heating region,
wherein the first cooling region and the second cooling region are arranged to be spaced apart from the rear chassis by a predetermined gap (P) along a third direction perpendicular to the first direction.

6. The display apparatus of any one of claims 2 to 4, wherein the heat pipe is formed using an extrusion method.

7. The display apparatus of claim 4 or 5, wherein the coolant located in the plurality of cooling channels (110) repeatedly alternates between a vapor plug and a liquid slug.

8. The display apparatus of any one of claims 4 to 6, further comprising a fastening device (700) configured to fix one or more of both ends of the plurality of cooling channels (110) to the rear chassis (30).

9. The display apparatus of any one of claims 2 to 7, wherein
the plurality of cooling channels (110) are arranged to be inclined at a predetermined inclination angle (θ) relative to the first direction, and
the inclination angle is 10 degrees or less.

10. The display apparatus of any one of claims 2 to 8, wherein
each cooling channel included in the plurality of cooling channels (110) has a rectangular cross-section perpendicular to the first direction,
a height (H) of the rectangular shape along the second direction perpendicular to the first direction is at least 2 mm but not more than 4 mm, and
a width (T) of the rectangular shape along the third direction perpendicular to the first direction is at least 0.5 mm but not more than 4 mm.

11. The display apparatus of any one of claims 1 to 9, wherein the heat pipe (100) comprises one or more of aluminum, copper, and stainless steel.

12. The display apparatus of any one of claims 2 to 10, wherein the coolant comprises one or more of refrigerant R-245fa, refrigerant R-1233zd, 3M Novec series, Chemours Opteon SF33, and distilled water.

13. The display apparatus of any one of claims 2 to 11, wherein
the plurality of cooling channels comprise
a first plurality of cooling channels (110-1) through which a first coolant flows, and a second plurality of cooling channels (110-2) through which a second coolant different from the first coolant flows,
wherein the first plurality of cooling channels are arranged adjacent to the second plurality of cooling channels along the second direction perpendicular to the first direction.

14. The display apparatus of claim 12, wherein the first plurality of cooling channels (110-1) and the second plurality of cooling channels (110-2) each include ten or fewer cooling channels aligned along the second direction perpendicular to the first direction.

15. The display apparatus of any one of claims 1 to 13, wherein the heat pipe (300) comprises a bent cooling channel (310) extending in one direction and integrally formed by being bent a plurality of times.

16. The display apparatus of any one of claims 1 to 14, wherein the heating device (40) comprises one or more of a printed circuit board (PCB) and a power input device.
